# EUROPÄISCHE PATENTSCHRIFT

(11) **EP 0 448 834 B1**
(45) Veröffentlichungstag und Bekanntmachung des Hinweises auf die Patenterteilung: **03.05.1995**
(21) Anmeldenummer: 90125312.0
(22) Anmeldetag: 22.12.1990
(51) Int. Cl.: H03K 3/2885, H03K 3/289, H03K 3/02, H03K 17/04

(54) **Integrierte Flip-Flop-Schaltung**
Integrated flip flop circuit
Circuit flip-flop intégré

(30) Priorität: 27.03.1990 DE 4009785
(43) Veröffentlichungstag der Anmeldung: 02.10.1991
(73) Patentinhaber: TEMIC TELEFUNKEN microelectronic GmbH, 74072 Heilbronn (DE)
(72) Erfinder: Tränkle, Günther, Dipl.-Phys., W-7910 Neu-Ulm 7 (DE)
(74) Vertreter: Maute, Hans-Jürgen, Dipl.-Ing.

(56) Entgegenhaltungen:
- DE-A- 2 018 150
- DE-B- 2 023 290
- DE-B- 2 339 289
- DE-B- 2 360 526
- DE-B- 2 405 500
- US-A- 3 714 471
- US-A- 4 320 314
- US-A- 4 622 475
- US-A- 4 800 296

## Beschreibung

Die Erfindung betrifft eine integrierte Flip-Flop-Schaltung nach dem Oberbegriff des Patentanspruchs 1.

Derartige Schaltungen sind allgemein bekannt. Dabei wird im wesentlichen ein Strom im Takt eines Eingangssignals zwischen verschiedenen Transistoren umgeschaltet, wobei das Kollektor-Potential eines jeweils strombelasteten Transistors durch den an der zugehörigen Lastimpedanz auftretenden Spannungsabfall gegenüber einem nicht strombelasteten Transistor absinkt. Die Kollektoranschlüsse dienen als Ausgänge der Schaltung zum Abgriff von Ausgangsspannungen.

Die parasitären Kapazitäten an den Kollektoranschlüssen bilden zusammen mit den Lastimpedanzen Tiefpässe, die eine obere Grenzfrequenz bestimmen. Andererseits bestimmen die Lastimpedanzen auch den Signalhub an den Schaltungsausgängen.

Der Erfindung liegt die Aufgabe zugrunde, eine Flip-Flop-Schaltung der im Oberbegriff des Patentanspruchs 1 genannten Art so auszubilden, daß ohne wesentliche Beeinträchtigung des Ausgangssignalhubs eine deutliche Erhöhung der oberen Grenzfrequenz möglich ist.

Die erfindungsgemäße Lösung dieser Aufgabe ist durch die kennzeichnenden Merkmale des Patentanspruchs 1 gegeben. Die abhängigen Ansprüche enthalten vorteilhafte Ausgestaltungen und Weiterbildungen der Erfindung.

Wesentlich bei der Erfindung ist die Aufteilung der Lastimpedanzen in erste Teilimpedanzen, die das Umschalten des Flip-Flops sichern und die Grenzfrequenz festlegen, einerseits und in zweite Teilimpedanzen, die den Signalhub an den Ausgängen der Schaltung bestimmen, andererseits und die Entkopplung der beiden Impedanzstufen durch je eine Basisschaltung-Trennstufe.

Durch die Aufteilung und Entkopplung können vorteilhafterweise die ersten Teilimpedanzen zur Erzielung einer hohen Grenzfrequenz niederohmig und die zweiten Teilimpedanzen für einen ausreichenden Ausgangssignalhub demgegenüber hochohmig gewählt werden.

Die Erfindung ist besonders vorteilhaft für Anwendungen, bei denen die Ausgangssignale der Schaltung unmittelbar Schaltelemente ansteuern.

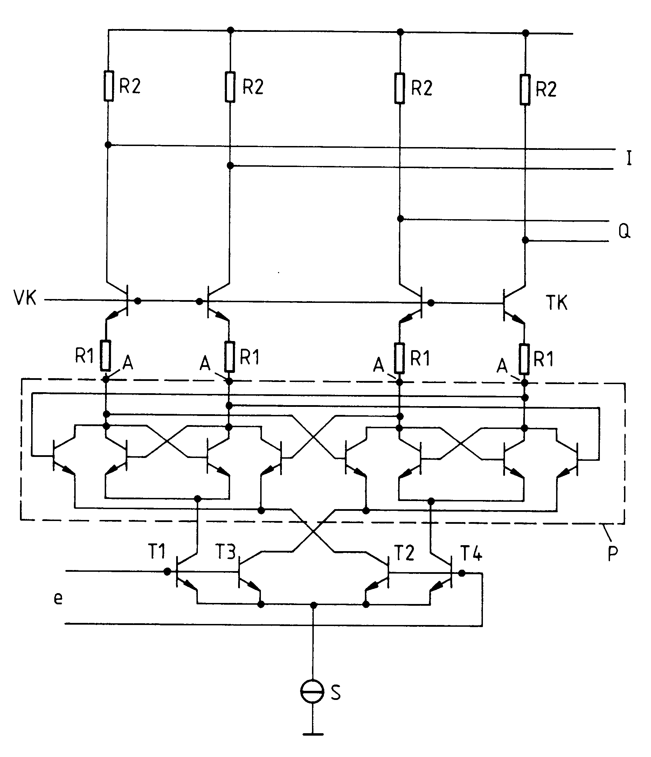

Die Erfindung ist nachfolgend anhand eines bevorzugten Ausführungsbeispiels unter Bezugnahme auf die Abbildung noch eingehend erläutert.

Die Abbildung zeigt ein Master-Slave-D-Flip-Flop in Toggle-Betrieb, bei welchem der durch eine Stromquelle S festgelegte Betriebsstrom über zwei von einem Eingangssignal e symmetrisch angesteuerte Stromschalter aus den Transistorpaaren T1, T2 und T3, T4 den beiden Flip-Flop-Stufen Master und Slave zugeführt ist. Der Aufbau und die Funktionsweise des skizzierten Master-Slave-D-Flip-Flops sind hinlänglich bekannt, so daß die eingezeichneten acht Transistoren der im Block P zusammengefaßten Master- und Slave-Stufen nicht im einzelnen bezeichnet und die verschiedenen Rückkopplungen nicht weiter erläutert sind. Andere Flip-Flop-Schaltungen sind in entsprechender Weise verwendbar, wobei aber der in P skizzierte FF-Aufbau die Vorteile geringer Komplexität und besonders hoher Grenzfrequenz, die aus dem geringen Ausgangshub in Verbindung mit den dadurch niedrigen Ausgangsimpedanzen resultiert, aufweist.

Die vier Kollektoranschlüsse A sind jeweils über eine Reihenschaltung von einer ersten Teilimpedanz R1, einer Basisschaltung-Trennstufe TK und einer zweiten Teilimpedanz R2 mit der Versorgungsspannung +U verbunden. An den Verbindungspunkten der zweiten Teilimpedanz mit den Kollektoranschlüssen der die Basisschaltung-Trennstufen bildenden Transistoren TK sind die Ausgangsspannungen abgegriffen, die beispielsweise zwei symmetrische, gegeneinander um 90°-phasenverschobene Quadratursteuersignale I und Q für eine Quadratur-Mischeranordnung bilden.

Die Basisanschlüsse aller Basisschaltung-Trennstufen sind untereinander verbunden und liegen an einer konstanten Spannung vk, so daß für die ersten Teilimpedanzen ein zumindest annähernd konstantes Zwischenpotential geschaffen wird.

Die ersten Teilimpedanzen sind, abhängig vom durchfließenden Strom, so zu wählen, daß ein sicheres und verzerrungsfreies Schalten gewährleistet ist, wofür im Regelfall bereits ein Spannungsabfall im stromführenden Zustand von < 100 mV ausreicht. Der Unterschied in der Basis-Emitterspannung der Transistoren TK zwischen sperrendem und stromführendem Zustand kann hierbei mit berücksichtigt werden.

Die zweiten Teilimpedanzen R2 sind im Sinne der Erfindung im Regelfall wesentlich hochohmiger als die ersten Teilimpedanzen.

Die erfindungsgemäße integrierte Flip-Flop-Schaltung ist besonders vorteilhaft einsetzbar als 0°/90°-Phasenteiler zur Erzeugung zweier um 90° gegeneinander phasenverschobener Ausgangssignale I und Q als Überlagerungssignale in einem Quadraturmischer. Gegenüber einer FF-Schaltung, bei welcher die Grenzfrequenz durch einfaches Verringern der Lastimpedanzen erreicht wird und zur Erlangung ausreichender Ansteuerpegel für den Quadraturmischer getrennte Schaltungen vorhanden sind, besitzt die skizzierte Schaltung den wesentlichen Vorteil, daß keine weiteren Phasenfehler in zusätzlichen Schaltungen auftreten und die Orthogonalität der I und Q-Signale durch Regelung der Eingangs- und Ausgangssingale der Flip-Flop-Schaltung gewährleistet werden kann.

## Patentansprüche

1. Integrierte Flip-Flop-Schaltung, insbesondere in Master-Slave-Anordnung, mit über Lastimpedanzen individuell mit einem Versorgungspotential verbundenen Kollektor-Ausgangsanschlüssen, dadurch gekennzeichnet, daß die Lastimpedanzen jeweils in Reihe eine unmittelbar mit dem jeweiligen Kollektor verbundene erste Teilimpedanz (R1), eine Basisschaltung-Trennstufe und eine zweite Teilimpedanz (R2) enthalten, daß die Basisanschlüsse aller Basisschaltung-Trennstufen auf gleichem Potential (vk) liegen und daß die Ausgangsspannungen der Schaltungen an den Verbindungspunkten der Basisschaltung-Trennstufen mit den zweiten Teilimpedanzen (R2) abgegriffen werden.

2. Schaltung nach Anspruch 1, dadurch gekennzeichnet, daß die ersten Teilimpedanzen (R1) niederohmig sind im Vergleich zu den zweiten Teilimpedanzen (R2).

3. Schaltung nach Anspruch 1 oder Anspruch 2, gekennzeichnet durch ihre Verwendung in einer Quadraturmischeranordnung zur Erzeugung zweier um 90° phasenverschobener Mischersignale.

## Claims

1. An integrated flip-flop circuit, in particular in a master-slave arrangement, with collector output terminals which are individually connected to a supply potential via load impedances, characterised in that the load impedances in each case comprise, in series, a first sub-impedance (R1) directly connected to the respective collector, a common-base circuit buffer stage, and a second sub-impedance (R2), that the base terminals of all the common-base circuit buffer stages carry the same potential (vk), and that the output voltages of the circuits are tapped at the points of connection of the common-base circuit buffer stages to the second sub-impedances (R2).

2. A circuit as claimed in Claim 1, characterised in that the first sub-impedances (R1) are low-ohmic compared to the second sub-impedances (R2).

3. A circuit as claimed in Claim 1 or Claim 2, characterised by its use in a quadrature mixer arrangement for the generation of two mixer signals shifted in phase by 90°.

## Revendications

1. Circuit bascule intégré, en particulier dans un dispositif maître-esclave, équipé de bornes de sortie de collecteur reliées individuellement, par l'intermédiaire d'impédances, à un potentiel d'alimentation,caractérisé en ce que les impédances de charge comportent respectivement en série une première impédance partielle (R1) reliée directement au collecteur respectif, un étage de séparation de circuit de base et une seconde impédance partielle (R2), en ce que les bornes de base de tous les étages de séparation de circuit de base se trouvent à un potentiel identique (vk) et en ce que les tensions de sortie des circuits peuvent être prélevées sur les points de liaison des étages de séparation de circuit de base avec les secondes impédances partielles (R2).

2. Circuit selon la revendication 1, caractérisé en ce que les premières impédances partielles (R1) sont de faible valeur ohmique en comparaison des secondes impédances partielles (R2).

3. Circuit selon la revendication 1 ou la revendication 2, caractérisé par son utilisation dans un mélangeur en quadrature en vue de la génération de deux signaux de mélangeur déphasés de 90°.
